# EUROPEAN PATENT APPLICATION

(11) **EP 2 433 981 A1**
(43) Date of publication of application: **28.03.2012**
(21) Application number: 10777842.5
(22) Date of filing: 21.05.2010
(51) Int. Cl.: C08J 7/00, B32B 27/16, G02F 1/1333, H01L 31/042, H05B 33/04, H05B 33/14

(54) **MOLDED OBJECT, PROCESS FOR PRODUCING SAME, MEMBER FOR ELECTRONIC DEVICE, AND ELECTRONIC DEVICE**

(30) Priority: 22.05.2009 JP 2009123828
(71) Applicant: LINTEC Corporation, Tokyo 173-0001 (JP)
(72) Inventor: HOSHI Shinichi, Tokyo 173-0001 (JP); SUZUKI Yuta, Tokyo 173-0001 (JP); Kondo Takeshi, Tokyo 173-0001 (JP)
(74) Representative: Beckmann, Claus
(86) International application number: PCT/JP2010/058671
(87) International publication number: WO 2010/134611

(57) **Abstract**

A formed article comprising a layer obtained by implanting ions into a polycarbosilane compound-containing layer, a method of producing the formed article, an electronic device member, and an electronic device comprising the electronic device member. The formed article has an excellent gas barrier capability, excellent transparency, excellent bendability, excellent adhesion, and excellent surface flatness.

## Description

### TECHNICAL FIELD

The present invention relates to a formed article, a method of producing the same, an electronic device member that includes the formed article, and an electronic device that includes the electronic device member.

### BACKGROUND ART

A polymer formed article such as a plastic film is inexpensive and exhibits excellent workability. Therefore, such a polymer formed article is provided with a desired function, and used in various fields.
In recent years, use of a transparent plastic film as a substrate having electrode instead of a glass plate has been proposed for displays (e.g., liquid crystal display and electroluminescence (EL) display) in order to implement a reduction in thickness, a reduction in weight, an increase in flexibility, and the like.
However, since such a plastic film easily allows water vapor, oxygen, and the like to pass through as compared with a glass plate, elements provided in a display may deteriorate.

In order to solve this problem, Patent Document 1 discloses a gas barrier film in which a gas barrier inorganic compound thin film is stacked on a polyester resin film.
However, the gas barrier capability of the laminate film disclosed in Patent Document 1 is not satisfactory. The laminate film disclosed in Patent Document 1 also has a problem in that a pinhole is easily formed in a layer formed on the gas barrier layer (inorganic compound thin film) due to insufficient surface flatness, and the gas barrier capability significantly decreases in an area in which a pinhole is formed. Moreover, since the film is formed by stacking a gas barrier layer formed of an inorganic compound on a base film formed of a polyester resin by a deposition method, an electron beam method, a sputtering method, or the like, the gas barrier capability may deteriorate by occurrence of cracks in the gas barrier layer when the laminate film is rounded or folded.
A method that alternately stacks inorganic films and organic films has been proposed in order to improve the bendability. However, this method results in a complex process, a decrease in adhesion, an increase in material cost, and the like.

### RELATED-ART DOCUMENT

### PATENT DOCUMENT

Patent Document 1: JP-A-10-305542

### SUMMARY OF THE INVENTION

### PROBLEMS TO BE SOLVED BY THE INVENTION

The present invention was conceived in view of the above situation. An object of the invention is to provide a formed article that exhibits an excellent gas barrier capability, excellent transparency, excellent bendability, excellent adhesion, and excellent surface flatness, a method of producing the same, an electronic device member that includes the formed article, and an electronic device that includes the electronic device member.

### MEANS FOR SOLVING THE PROBLEMS

The inventors of the invention conducted extensive studies to achieve the above object. As a result, the inventors found that a formed article obtained by implanting ions into a surface of a polycarbosilane compound-containing layer of a formed body that includes the polycarbosilane compound-containing layer in its surface exhibits an excellent gas barrier capability, excellent transparency, excellent bendability, excellent adhesion, and excellent surface flatness. This finding has led to the completion, of the invention.

A first aspect of the present invention provides the following formed article (see (i) to (iv)).
(i) A formed article including a layer obtained by implanting ions into a polycarbosilane compound-containing layer.
(ii) The formed article according to (i), wherein the polycarbosilane compound includes a repeating unit shown by a formula (1),

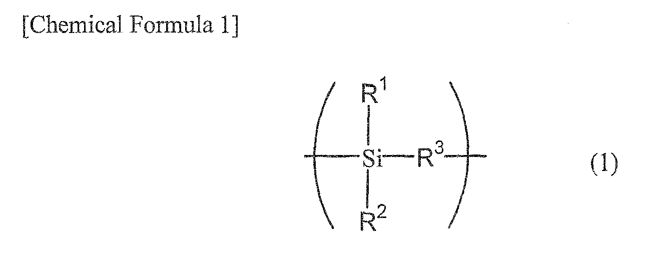

wherein R¹ and R² individually represent a hydrogen atom, a hydroxyl group, an alkyl group, an aryl group, an aralkyl group, an alkenyl group, or a monovalent heterocyclic group, provided that R¹ and R² may respectively be either the same or different, and R³ represents an alkylene group, an arylene group, or a divalent heterocyclic group.

(iii) The formed article according to (i) or (ii), wherein the layer is obtained by implanting ions into the polycarbosilane compound-containing layer by a plasma ion implantation method.
(iv) The formed article according to any one of (i) to (iii), the formed article having a water vapor transmission rate at a temperature of 40°C and a relative humidity of 90% of less than 0.3 g/m²/day.

A second aspect of the invention provides the following method of producing a formed article (see (v) and (vi)).
(v) A method of producing the formed article according to (i), the method including implanting ions into a surface of a polycarbosilane compound-containing layer of a formed body that includes the polycarbosilane compound-containing layer in its surface.
(vi) The method according to (v), including implanting ions into the polycarbosilane compound-containing layer while feeding a long formed body that includes the polycarbosilane compound-containing layer in its surface in a given direction.

A third aspect of the invention provides the following electronic device member (see (vii)).
(vii) An electronic device member including the formed article according to any one of (i) to (iv).
   A fourth aspect of the invention provides the following electronic device (see (viii)).
(viii) An electronic device including the electronic device member according to (vii).

### EFFECTS OF THE INVENTION

The formed article according to the first aspect of the invention exhibits an excellent gas barrier capability, excellent bendability, excellent surface flatness, good transparency, and high adhesion. Therefore, the formed article may suitably be used as an electronic device member (e.g., solar battery backsheet) for flexible displays, solar batteries, and the like.
The method of producing a formed article according to the second aspect of the invention can safely and easily produce the formed article according to the first aspect of the invention that exhibits an excellent gas barrier capability, excellent transparency, and the like. Moreover, an increase in area can be easily achieved at low cost as compared with the case of depositing an inorganic film.
Since the electronic device member according to the third aspect of the invention exhibits an excellent gas barrier capability, excellent transparency, and the like, the electronic device member may suitably be used for electronic devices such as displays and solar batteries.

### BRIEF DESCRIPTION OF THE DRAWINGS

FIG. 1 is a view showing a schematic configuration of a plasma ion implantation apparatus used in the present invention.
FIG. 2 is a view showing a schematic configuration of a plasma ion implantation apparatus used in the present invention.

### DESCRIPTION OF EXEMPLARY EMBODIMENTS

A formed article, a method of producing a formed article, an electronic device member, and an electronic device according to embodiments of the invention are described in detail below.

### 1) Formed article

A formed article according to one embodiment of the invention includes a layer obtained by implanting ions into a polycarbosilane compound-containing layer (hereinafter referred to as "ion-implanted layer").

The term "polycarbosilane compound" used herein refers to a polymer compound that includes a repeating unit including an -Si-C- bond in the main chain of the molecule. A compound that includes a repeating unit shown by the following formula (1) is preferable as the polycarbosilane compound.

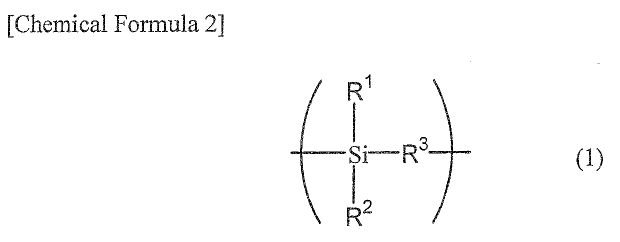

wherein R¹ and R² individually represent a hydrogen atom, a hydroxyl group, an alkyl group, an aryl group, an aralkyl group, an alkenyl group, or a monovalent heterocyclic group, provided that R¹ and R² may respectively be either the same or different.

Examples of the alkyl group represented by R¹ and R² include chain-like alkyl groups having 1 to 10 carbon atoms such as a methyl group, an ethyl group, an n-propyl group, an isopropyl group, an n-butyl group, an isobutyl group, a s-butyl group, a t-butyl group, an n-pentyl group, an n-hexyl group, an n-heptyl group, an n-octyl group, an n-nonyl group, and an n-decyl group, and cyclic alkyl groups having 3 to 10 carbon atoms such as a cyclopropyl group, a cyclobutyl group, a cyclopentyl group, a cyclohexyl group, and a cyclooctyl group.

Examples of the aryl group include aryl groups having 6 to 20 carbon atoms such as a phenyl group, an α-naphthyl group, and a β-naphthyl group.
Examples of the aralkyl group include aralkyl groups having 7 to 20 carbon atoms such as a benzyl group, a phenethyl group, a 3-phenylpropyl group, a 4-phenylbutyl group, a 5-phenylpentyl group, a 6-phenylhexyl group, an α-naphthylmethyl group, and a β-naphthylmethyl group.

Examples of the alkenyl group include alkenyl groups having 2 to 10 carbon atoms such as a vinyl group, a 1-propenyl group, a 2-propenyl group, a 1-butenyl group, a 2-butenyl group, a 2-pentenyl group, a 3-pentenyl group, a 1-hexenyl group, a 2-hexenyl group, a 3-hexenyl group, a 4-hexenyl group, and a 5-hexenyl group.

The heterocyclic ring of the monovalent heterocyclic group is not particularly limited as long as the heterocyclic ring is derived from a 3 to 10-membered cyclic compound that includes a carbon atom and at least one heteroatom (e.g., oxygen atom, nitrogen atom, or sulfur atom).
Specific examples of the monovalent heterocyclic group include a 2-pyridyl group, a 3-pyridyl group, a 4-pyridyl group, a 2-thienyl group, a 3-thienyl group, a 2-furyl group, a 3-furyl group, a 3-pyrazolyl group, a 4-pyrazolyl group, a 2-imidazolyl group, a 4-imidazolyl group, a 1,2,4-triazin-3-yl group, a 1,2,4-triazin-5-yl group, a 2-pyrimidyl group, a 4-pyrimidyl group, a 5-pyrimidyl group, a 3-pyridazyl group, a 4-pyridazyl group, a 2-pyrazyl group, a 2-(1,3,5-triazyl) group, a 3-(1,2,4-triazyl) group, a 6-(1,2,4-triazyl) group, a 2-thiazolyl group, a 5-thiazolyl group, a 3-isothiazolyl group, a 5-isothiazolyl group, a 2-(1,3,4-thiadiazolyl) group, a 3-(1,2,4-thiadiazolyl) group, a 2-oxazolyl group, a 4-oxazolyl group, a 3-isoxazolyl group, a 5-isoxazolyl group, a 2-(1,3,4-oxadiazolyl) group, a 3-(1,2,4-oxadiazolyl) group, a 5-(1,2,3-oxadiazolyl) group, and the like.

When R¹ and R² represent an aryl group, an aralkyl group, an alkenyl group, or a monovalent heterocyclic group, these groups may include a substituent, such as an alkyl group (e.g., methyl group or ethyl group), a phenyl group, a 4-methylphenyl group, an aryl group, an alkoxy group (e.g., methoxy group or ethoxy group), an aryloxy group (e.g., phenoxy group), a halogen atom (e.g., fluorine atom or chlorine atom), a nitro group, or a cyano group, at an arbitrary position.

R³ represents an alkylene group, an arylene group, or a divalent heterocyclic group.
Examples of the alkylene group represented by R³ include alkylene groups having 1 to 10 carbon atoms such as a methylene group, an ethylene group, a propylene group, a trimethylene group, a tetramethylene group, a pentamethylene group, a hexamethylene group, and an octamethylene group.

Examples of the arylene group include arylene groups having 6 to 20 carbon atoms such as a 1,4-phenylene group, a 1,3-phenylene group, a 1,4-naphthylene group, and a 2,5-naphthylene group.

The divalent heterocyclic group is not particularly limited as long as the divalent heterocyclic group is a divalent group derived from a 3 to 10-membered cyclic compound that includes a carbon atom and at least one heteroatom (e.g., oxygen atom, nitrogen atom, or sulfur atom).

Specific examples of the divalent heterocyclic group include a thiophenediyl group such as a 2,5-thiophenediyl group; a furandiyl group such as a 2,5-furandiyl group; a selenophenediyl group such as a 2,5-selenophenediyl group; a pyrrolediyl group such as a 2,5-pyrrolediyl group; a pyridinediyl group such as a 2,5-pyridinediyl group and a 2,6-pyridinediyl group; a thiophenediyl group such as a 2,5-thieno[3,2-b]thiophenediyl group and a 2,5-thieno[2,3-b]thiophenediyl group; a quinolinediyl group such as a 2,6-quinolinediyl group; an isoquinolinediyl group such as a 1,4-isoquinolinediyl group and a 1,5-isoquinolinediyl group; a quinoxalinediyl group such as a 5,8-quinoxalinediyl group; a benzo[1,2,5]thiadiazolediyl group such as a 4,7-benzo[1,2,5]thiadiazolediyl group; a benzothiazolediyl group such as a 4,7-benzothiazolediyl group; a carbazolediyl group such as a 2,7-carbazolediyl group and a 3,6-carbazolediyl group; a phenoxazinediyl group such as a 3,7-phenoxazinediyl group; a phenothiazinediyl group such as a 3,7-phenothiazinediyl group; a dibenzosilolediyl group such as a 2,7-dibenzosilolediyl group; a benzodithiophenediyl group such as a 2,6-benzo[1,2-b:4,5-b']dithiophenediyl group, 2,6-benzo[1,2-b:5,4-b']dithiophenediyl group, 2,6-benzo[2,1-b:3,4-b']dithiophenediyl group, 2,6-benzo[1,2-b:3,4-b']dithiophenediyl group; and the like.

The alkylene group, the arylene group, or the divalent heterocyclic group represented by R³ may include a substituent (e.g., alkyl group, aryl group, alkoxy group, halogen atom, nitro group, or cyano group) at an arbitrary position. Specific examples of the substituent include the substituents mentioned above in connection with the aryl group or the like represented by R¹ and R².

It is preferable that the polycarbosilane compound include a repeating unit shown by the formula (1) wherein R¹ and R² individually represent a hydrogen atom, an alkyl group, or an aryl group, and R³ represents an alkylene group or an arylene group. It is more preferable that the polycarbosilane compound include a repeating unit shown by the formula (1) wherein R¹ and R² individually represent a hydrogen atom or an alkyl group, and R³ represents an alkylene group. It is particularly preferable that the polycarbosilane compound include a repeating unit shown by the formula (1) wherein R¹ and R² individually represent a hydrogen atom or an alkyl group having 1 to 4 carbon atoms, and R³ represents an alkylene group having 1 to 6 carbon atoms.

The weight average molecular weight of the polycarbosilane compound that includes a repeating unit shown by the formula (1) is normally 400 to 12,000.

The polycarbosilane compound may be produced by an arbitrary method. For example, the polycarbosilane compound may be produced a method that produces a polycarbosilane compound by thermal decomposition and polymerization of a polysilane (JP-A-51-126300), a method that produces a polycarbosilane compound by thermal rearrangement of poly(dimethylsilane) (Journal of Materials Science, 2569-2576, Vol. 13, 1978), a method that produces a polycarbosilane compound by a Grignard reaction of chloromethyltrichlorosilane (Organometallics, 1336-1344, Vol. 10, 1991), a method that produces a polycarbosilane compound by ring-opening polymerization of a disilacyclobutane (Journal of Organometallic Chemistry, 1-10, Vol. 521, 1996), a method that produces a polycarbosilane compound by reacting water and/or an alcohol with a raw material polymer that includes a dimethylcarbosilane structural unit and an SiH group-containing silane structural unit in the presence of a basic catalyst (JP-A-2006-117917), a method that produces a polycarbosilane compound by polymerizing a carbosilane that includes an organometallic group (e.g., trimethyltin) at the end using an organic main-group metal compound (e.g., n-butyllithium) as an initiator (JP-A-2001-328991), or the like.

The polycarbosilane compound-containing layer may include an additional component other than the polycarbosilane compound as long as the object of the invention is not impaired. Examples of the additional component include a curing agent, another polymer, an aging preventive, a light stabilizer, a flame retardant, and the like.

The content of the polycarbosilane compound in the polycarbosilane compound-containing layer is preferably 50 wt% or more, and more preferably 70 wt% or more, from the viewpoint of obtaining an ion-implanted layer that exhibits an excellent gas barrier capability.

The polycarbosilane compound-containing layer may be formed by an arbitrary method. For example, the polycarbosilane compound-containing layer may be formed by applying a solution that includes at least one polycarbosilane compound, an optional component, and a solvent to an appropriate base, and drying moderately the resulting film.

A spin coater, a knife coater, a gravure coater, or the like may be used as the coater.

It is preferable to heat the film when drying the film in order to improve the gas barrier capability of the resulting formed article. In this case, the film is heated at 80 to 150°C for several tens of seconds to several tens of minutes.

The thickness of the polycarbosilane compound-containing layer is not particularly limited, but is normally 20 to 1000 nm, preferably 30 to 500 nm, and more preferably 40 to 200 nm.
According to the invention, a formed article that exhibits a sufficient gas barrier capability can be obtained even if the thickness of the polycarbosilane compound-containing layer is of the order of nanometers.

The ion-implanted layer included in the formed article according to one embodiment of the invention is not particularly limited as long as the ion-implanted layer is a layer which includes at least one polycarbosilane compound and into which ions are implanted.

The ion-implanted layer is obtained by implanting ions into the polycarbosilane compound-containing layer.
The dose may be appropriately determined depending on the application (usage) of the resulting formed article (e.g., gas barrier capability and transparency required for the application), and the like.

Examples of ions implanted into the polycarbosilane compound-containing layer include ions of rare gas such as argon, helium, neon, krypton, or xenon; ions of a fluorocarbon, hydrogen, nitrogen, oxygen, carbon dioxide, chlorine, fluorine, sulfur, or the like; ions of an alkane gas such as methane, ethane, propane, butane, pentane, or hexane; ions of an alkene gas such as ethylene, propylene, butene, or pentene; ions of an alkadiene gas such as pentadiene or butadiene; ions of an alkyne gas such as acetylene or methylacetylene; ions of an aromatic hydrocarbon gas such as benzene, toluene, xylene, indene, naphthalene, or phenanthrene; ions of a cycloalkane gas such as cyclopropane or cyclohexane; ions of a cycloalkene gas such as cyclopentene or cyclohexene; ions of a conductive metal such as gold, silver, copper, platinum, nickel, palladium, chromium, titanium, molybdenum, niobium, tantalum, tungsten, or aluminum; ions of silane (SiH₄) or an organosilicon compound; and the like.

Examples of the organosilicon compound include tetraalkoxysilanes such as tetramethoxysilane, tetraethoxysilane, tetra-n-propoxysilane, tetraisopropoxysilane, tetra-n-butoxysilane, and tetra-t-butoxysilane; substituted or unsubstituted alkylalkoxysilanes such as dimethyldimethoxysilane, dimethyldiethoxysilane, diethyldimethoxysilane, methyltriethoxysilane, ethyltrimethoxysilane, and (3,3,3-trifluoropropyl)trimethoxysilane; arylalkoxysilanes such as diphenyldimethoxysilane and phenyltriethoxysilane; disiloxanes such as hexamethyldisiloxane (HMDSO); aminosilanes such as bis(dimethylamino)dimethylsilane, bis(dimethylamino)methylvinylsilane, bis(ethylamino)dimethylsilane, diethylaminotrimethylsilane, dimethylaminodimethylsilane, tetrakisdimethylaminosilane, and tris(dim.ethylamino)silane; silazanes such as hexamethyldisilazane, hexamethyleyelotrisilazane, heptamethyldisilazane, nonamethyltrisilazane, octamethylcyclotetrasilazane, and tetramethyldisilazane; isocyanatosilanes such as tetraisocyanatosilane; halogenosilanes such as triethoxyfluorosilane; alkenylsilanes such as diallyldimethylsilane and allyltrimethylsilane; substituted or unsubstituted alkylsilanes such as di-t-butylsilane, 1,3-disilabutane, bis(trimethylsilyl)methane, trimethylsilane, tetramethylsilane, tris(trimethylsilyl)methane, tris(trimethylsilyl)silane, and benzyltrimethylsilane; silylalkynes such as bis(trimethylsilyl)acetylene, trimethylsilylacetylene, and 1-(trimethylsilyl)-1-propyne; silylalkenes such as 1,4-bistrimethylsilyl-1,3-butadiyne and cyclopentadienyltrimethylsilane; arylalkylsilanes such as phenyldimethylsilane and phenyltrimethylsilane; alkynylalkylsilanes such as propargyltrimethylsilane; alkenylalkylsilanes such as vinyltrimethylsilane; disilanes such as hexamethyldisilane; siloxanes such as octamethylcyclotetrasiloxane, tetramethylcyclotetrasiloxane, and hexamethylcyclotctrasiloxane; N,O-bis(trimetliylsilyl)acetamide; bis(trimethylsilyl)carbodiimide; and the like.
These ions may be used either individually or in combination.

Among these, at least one ion selected from the group consisting of ions of hydrogen, nitrogen, oxygen, argon, helium, neon, xenon, and krypton is preferable due to ease of implantation and a capability to form an ion-implanted layer that exhibits an excellent gas barrier capability and excellent transparency.

The ion implantation method is not particularly limited. For example, a method that includes after forming a polycarbosilane compound-containing layer, implanting ions into the polycarbosilane compound-containing layer may be used.

Ions may be implanted by applying ions (ion beams) accelerated by an electric field, implanting ions present in plasma (plasma ion implantation method), or the like. It is preferable to use a plasma ion implantation method since a formed article that exhibits a gas barrier capability can be easily obtained.

Plasma ion implantation may be implemented by generating plasma in an atmosphere containing a plasma-generating gas (e.g., rare gas), and implanting ions (cations) in the plasma into the surface of the polycarbosilane compound-containing layer by applying a negative high-voltage pulse to the polycarbosilane compound-containing layer, for example.

The thickness of the ion-implanted layer may be controlled depending on the implantation conditions (e.g., type of ion, applied voltage, and implantation time), and may be determined depending on the thickness of the polycarbosilane compound-containing layer, the application (object) of the formed article, and the like. The thickness of the ion-implanted layer is normally 10 to 1000 nm.

Whether or not an ion-implanted layer has been formed may be determined by performing elemental analysis in an area having a depth of about 10 nm from the surface by X-ray photoelectron spectroscopy (XPS).

The shape of the formed article according to one embodiment of the invention is not particularly limited. For example, the formed article may be in the shape of a film, a sheet, a rectangular parallelepiped, a polygonal prism, a tube, or the like. When using the formed article as an electronic device member (described later), the formed article is preferably in the shape of a film or a sheet. The thickness of the film may be appropriately determined depending on the desired application of the electronic device.

The formed article according to one embodiment of the invention may include only the ion-implanted layer, or may also include an additional layer other than the ion-implanted layer. The additional layer may be a single layer, or may include a plurality of identical or different layers. Examples of the additional layer include a base, an inorganic thin film layer, a conductor layer, an impact-absorbing layer, a primer layer, and the like that are formed of a material other than the polycarbosilane compound.

The material for the base is not particularly limited as long as the application of the formed article is not hindered. Examples of the material for the base include polyimides, polyamides, polyamideimides, polyphenylene ethers, polyether ketones, polyether ether ketones, polyolefins, polyesters, polycarbonates, polysulfones, polyether sulfones, polyphenylene sulfides, polyallylates, acrylic resins, cycloolefin polymers, aromatic polymers, and the like.

Among these, polyesters, polyamides, or cycloolefin polymers are preferable due to versatility. It is more preferable to use polyesters.

Examples of polyesters include polyethylene terephthalate, polybuthylene terephthalate, polyethylene naphthalate, polyallylate, and the like.
Examples of polyamides include wholly aromatic polyamides, nylon 6, nylon 66, nylon copolymers, and the like.

Examples of cycloolefin polymers include norbornene polymers, monocyclic olefin polymers, cyclic conjugated diene polymers, vinyl alicyclic hydrocarbon polymers, and hydrogenated products thereof. Specific examples of cycloolefin polymers include APEL (ethylene-cycloolefin copolymer manufactured by Mitsui Chemicals Inc.), ARTON (norbornene polymer manufactured by JSR Corporation), ZEONOR (norbornene polymer manufactured by Zeon Corporation), and the like.

The thickness of the base is not particularly limited, but is normally 5 to 1000 µm, and preferably 10 to 300 µm.

The inorganic thin film layer includes one or more inorganic compounds. Examples of the inorganic compounds include inorganic compounds that can be deposited under vacuum, and exhibit a gas barrier capability, such as inorganic oxides, inorganic nitrides, inorganic carbides, inorganic sulfides, and composites thereof (e.g., inorganic oxynitride, inorganic oxycarbide, inorganic carbonitride, and inorganic oxycarbonitride).

The thickness of the inorganic thin film layer is normally 10 to 1000 nm, preferably 20 to 500 nm, and more preferably 20 to 100 nm.

Examples of the material used for the conductor layer include a metal, an alloy, a metal oxide, an electrically conductive compound, a mixture thereof, and the like. Specific examples of the material used for the conductor layer include semi conductive metal oxides such as antimony-doped tin oxide (ATO), fluorine-doped tin oxide (FTO), tin oxide, zinc oxide, indium oxide, indium tin oxide (ITO), and indium zinc oxide (IZO); metals such as gold, silver, chromium, and nickel; a mixture of a metal and a conductive metallic oxide; inorganic conductive substances such as copper iodide and copper sulfide; organic conductive materials such as polyaniline, polythiophene, and polypyrrole; and the like.

The conductor layer may be formed by an arbitrary method. For example, the conductor layer may be formed by deposition, sputtering, ion plating, thermal CVD, plasma CVD, or the like.

The thickness of the conductor layer may be appropriately selected depending on the application and the like. The thickness of the conductor layer is normally 10 nm to 50 µm, and preferably 20 nm to 20 µm.

The material used for the impact-absorbing layer is not particularly limited. Examples of the material used for the impact-absorbing layer include acrylic resins, urethane resins, silicone resins, olefin resins, rubber materials, and the like.
A product commercially available as a pressure-sensitive adhesive, a coating agent, a sealing material, or the like may also be used as the material for the impact-absorbing layer. It is preferable to use a pressure-sensitive adhesive (e.g., acrylic based pressure-sensitive adhesive, silicone based pressure-sensitive adhesive, or rubber based pressure-sensitive adhesive).

The impact-absorbing layer may be formed by an arbitrary method. For example, the impact-absorbing layer may be formed by applying a solution that includes the material (e.g., pressure-sensitive adhesive) for the impact-absorbing layer and an optional component (e.g., solvent) to the layer on which the impact-absorbing layer is to be formed, drying the resulting film, and optionally heating the dried film in the same manner as in the case of forming the polycarbosilane compound-containing layer.
Alternatively, the impact-absorbing layer may be formed on a release base, and transferred to a layer on which the impact-absorbing layer is to be formed.
The thickness of the impact-absorbing layer is normally 1 to 100 µm, and preferably 5 to 50 µm.

The primer layer improves the interlayer adhesion between the base and the polycarbosilane compound-containing layer. A formed article that exhibits excellent interlayer adhesion and surface flatness can be obtained by providing the primer layer.

An arbitrary material may be used to form the heretofore known primer layer. Examples of the material that may be used to form the primer layer include silicon-containing compounds; a photopolymerizable composition that includes a photopolymerizable compound formed of a photopolymerizable monomer and/or a photopolymerizable prepolymer, and an initiator that generates radicals at least due to visible light; resins such as a polyester resin, a polyurethane resin (particularly a two-component curable resin that includes an isocyanate compound and a polyacryl polyol, a polyester polyol, a polyether polyol, or the like), an acrylic resin, a polycarbonate resin, a vinyl chloride/vinyl acetate copolymer, a polyvinyl butyral resin, and a nitrocellulose resin; alkyl titanates; ethyleneimine; and the like. These materials may be used either individually or in combination.

The primer layer may be forked by dissolving or dispersing the material used to form the primer layer in an appropriate solvent to prepare a primer layer-forming solution, applying the primer layer-forming solution to one side or each side of the base, drying the resulting film, and optionally heating the dried film.

The primer layer-forming solution may be applied to the base by a wet coating method. Examples of the wet coating method include dipping, roll coating, gravure coating, knife coating, air knife coating, roll knife coating, die coating, screen printing, spray coating, a gravure offset method, and the like.

The film formed using the primer layer-forming solution may be dried by hot-air drying, heat roll drying, infrared irradiation, or the like. The thickness of the primer layer is normally 10 to 1000 nm.

Ions may be implanted into the primer layer in the same manner as in the case of forming the ion-implanted layer (described later). A formed article that exhibits a more excellent gas barrier capability can be obtained by implanting ions into the primer layer.

When the formed article according to one embodiment of the invention is a laminate that includes the additional layer, the ion-implanted layer may be situated at an arbitrary position. The number of ion-implanted layers may be one or more.

The formed article according to one embodiment of the invention exhibits an excellent gas barrier capability, and preferably exhibits excellent bendability, and maintains the gas barrier capability upon folding (bending) when the formed article has a film-shape or sheet-shape (hereinafter referred to as "film-shape").

It can be confirmed that the formed article according to one embodiment of the invention exhibits an excellent gas barrier capability since the formed article has a significantly low gas (e.g., water vapor) transmission rate as compared with the case where ions are not implanted into the formed body. For example, the water vapor transmission rate of the formed article at a temperature of 40°C and a relative humidity of 90% is preferably 0.30 g/m²/day or less, and more preferably 0.25 g/m²/day or less.
The gas (e.g., water vapor) transmission rate of the formed article may be measured using a known gas transmission rate measuring apparatus.

It can be confirmed that The formed article according to one embodiment of the invention exhibits excellent transparency since the formed article has a high visible light transmittance. The visible light transmittance wavelength: 550 nm of the formed article is preferably 78% or more. The visible light transmittance of the formed article may be measured using a known visible light transmittance measuring apparatus.

Whether or not the formed article according to one embodiment of the invention exhibits excellent bendability, and maintains the gas barrier capability when the formed article is folded may be determined by folding the film-shaped formed article, applying a pressure to the film-shaped formed article, and determining whether or not the water vapor transmission rate has decreased to a large extent after unfolding the formed article. The film-shaped formed article according to one embodiment of the invention advantageously maintains the gas barrier capability as compared with an inorganic film having an identical thickness even when the formed article has been folded.

The formed article according to one embodiment of the invention also exhibits excellent surface flatness. Whether or not the formed article according to one embodiment of the invention exhibits excellent surface flatness may be determined by measuring the surface roughness Ra (nm) (measurement area: 1×1 µm) of the formed article using an atomic force microscope (AFM). The surface roughness Ra (measurement area: 1×1 µm) of the formed article is preferably 0.25 nm or less.

### 2) Method of producing formed article

A method of producing a formed article according to one embodiment of the invention includes implanting ions into a polycarbosilane compound-containing layer of a formed body that includes the polycarbosilane compound-containing layer in its surface.

The method of producing a formed article according to one embodiment of the invention preferably includes implanting ions into the polycarbosilane compound-containing layer while feeding a long formed body that includes the polycarbosilane compound-containing layer in its surface in a given direction.
According to this method, ions can be implanted into a long formed body fed out from a feed-out roll while feeding the formed body in a given direction, which can then be wound around a wind-up roll, for example. Therefore, an ion-implanted formed article can be continuously produced.

The long formed body may be in the shape of a film comprised of only the polycarbosilane compound-containing layer, or composed of an additional layer other than the polycarbosilane compound-containing layer. Examples of the additional layer include a base formed of a material other than the polycarbosilane compound. The base mentioned above may be used.

The thickness of the formed body is preferably 1 to 500 µm, and more preferably 5 to 300 µm, from the viewpoint of operability of winding/unwinding and feeding.

Ions may be implanted into the polycarbosilane compound-containing layer by an arbitrary method. It is preferable to form an ion-implanted layer in the surface of the polycarbosilane compound-containing layer by a plasma ion implantation method.

The plasma ion implantation method includes implanting ions present in plasma into the surface of the polycarbosilane compound-containing layer by applying a negative high-voltage pulse to the formed body that includes the polycarbosilane compound-containing layer in its surface and has been exposed to plasma.

As the plasma ion implantation method, it is preferable to use (A) a method that implants ions present in plasma generated by utilizing an external electric field into the surface of the polycarbosilane compound-containing layer, or (B) a method that implants ions present in plasma generated due to an electric field produced by applying a negative high-voltage pulse to the polycarbosilane compound-containing layer into the surface of the polycarbosilane compound-containing layer.

When using the method (A), it is preferable to set the ion implantation pressure (plasma ion implantation, pressure) to 0.01 to 1 Pa. If the plasma ion implantation pressure is within the above range, a uniform ion-implanted layer can be formed conveniently and efficiently. This makes it possible to efficiently form an ion-implanted layer that exhibits bendability and a gas barrier capability.

The method (B) does not require increasing the degree of decompression, allows an easy operation, and significantly reduces the processing time. Moreover, the entire polycarbosilane compound-containing layer can be uniformly processed, and ions present in plasma can be continuously implanted into the surface of the polycarbosilane compound-containing layer with high energy when applying a negative high-voltage pulse. The method (B) also has an advantage in that an excellent ion-implanted layer can be uniformly formed in the surface of the polycarbosilane compound-containing layer by merely applying a negative high-voltage pulse to the polycarbosilane compound-containing layer without requiring a special means such as a high-frequency power supply (e.g., radio frequency (RF) power supply or microwave power supply).

When using the method (A) or (B), the pulse width when applying a negative high-voltage pulse (i.e., during ion implantation) is preferably 1 to 15 µsec. If the pulse width is within the above range, a uniform ion-implanted layer can be formed more conveniently and efficiently.

The voltage applied when generating plasma is preferably -1 to -50 kV, more preferably -1 to -30 kV, and particularly preferably -5 to -20 kV. If the applied voltage is higher than -1 kV, the dose may be insufficient, so that the desired performance may not be obtained. If the applied voltage is lower than -50 kV, the formed article may be charged during ion implantation, or the formed article may be colored.

Examples of the ion species to be plasma-implanted include the implantation target ions mentioned above.

A plasma ion implantation apparatus is used when implanting ions present in the plasma into the surface of the polycarbosilane compound-containing layer.
Specific examples of the plasma ion implantation apparatus include (α) an apparatus that causes the polycarbosilane compound-containing layer (hereinafter may be referred to as "ion implantation target layer") to be evenly enclosed by plasma by superimposing high-frequency electric power on a feed-through that applies a negative high-voltage pulse to the ion implantation target layer so that ions present in plasma are attracted, implanted, collide, and deposited (JP-A-2001-26887), (β) an apparatus that includes an antenna in a chamber, wherein high-frequency electric power is applied to generate plasma, positive and the negative pulses are alternately applied to the ion implantation target layer after plasma has reached an area around the ion implantation target layer, so that ions present in plasma are attracted and implanted by heating the ion implantation target layer by causing electrons present in plasma to be attracted and collide due to the positive pulse, and applying the negative pulse while controlling the temperature by controlling the pulse factor (JP-A-2001-156013), (γ) a plasma ion implantation apparatus that generates plasma using an external electric field utilizing a high-frequency power supply such as a microwave power supply, and causes ions present in plasma to be attracted and implanted by applying a high-voltage pulse, (δ) a plasma ion implantation apparatus that implants ions present in plasma generated due to an electric field produced by applying a high-voltage pulse without using an external electric field, and the like.

It is preferable to use the plasma ion implantation apparatus (γ) or (δ) since the plasma ion implantation apparatus (γ) or (δ) allows a convenient operation, significantly reduces the processing time, and can be continuously used.
A method using the plasma ion implantation apparatus (γ) or (δ) is described in detail below with reference to the drawings.

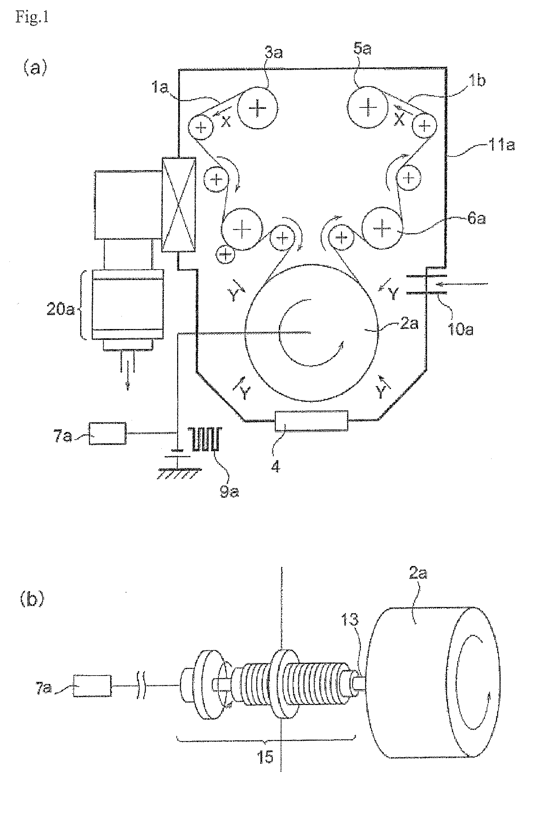

FIG. 1 is a view schematically showing a continuous plasma ion implantation apparatus that includes the plasma ion implantation apparatus (γ).
In FIG. 1(a), reference symbol 1a indicates a long film-shaped formed body (hereinafter referred to as "film") that includes a polycarbosilane compound-containing layer in its surface, reference symbol 11a indicates a chamber, reference symbol 20a indicates a turbo-molecular pump, reference symbol 3 a indicates a feed-out roll around which the film 1a is wound before ion implantation, reference symbol 5a indicates a wind-up roll around which an ion-implanted film (formed article) 1b is wound, reference symbol 2a indicates a high-voltage-applying rotary can, reference symbol 6a indicates a driving roll, reference symbol 10a indicates a gas inlet, reference symbol 7a indicates a high-voltage pulse power supply, and reference symbol 4 indicates a plasma discharge electrode (external electric field). FIG. 1(b) is a perspective view showing the high-voltage-applying rotary can 2a, wherein reference numeral 15 indicates a high-voltage application terminal (feed-through).

The long film 1a that includes a polycarbosilane compound-containing layer in its surface is a film in which a polycarbosilane compound-containing layer is formed on a base (additional layer).

In the continuous plasma ion implantation apparatus shown in FIG. 1, the film 1a is fed from the feed-out roll 3a in an arrow direction X inside the chamber 11a, passes through the high-voltage-applying rotary can 2a, and is wound around the wind-up roll 5a. The film 1a may be wound and fed by an arbitrary method. In one embodiment, the film 1a is fed by rotating the high-voltage-applying rotary can 2a at a constant speed. The high-voltage-applying rotary can 2a is rotated by rotating a center shaft 13 of the high-voltage application terminal 15 using a motor.

The high-voltage application terminal 15, the driving rolls 6a that come in contact with the film 1a, and the like are formed of an insulator. For example, the high-voltage application terminal 15, the driving rolls 6a, and the like are formed by coating the surface of alumina with a resin (e.g., polytetrafluoro ethylene). The high-voltage-applying rotary can 2a is formed of a conductor (e.g., stainless steel).

The feed speed of the film 1a may be appropriately set. The feed speed of the film 1a is not particularly limited as long as ions are implanted into the surface (polycarbosilane compound-containing layer) of the film 1a so that the desired implanted layer is formed when the film 1a is fed from the feed-out roll 3 a and wound around the wind-up roll 5a. The film winding speed (feed speed) is determined depending on the applied voltage, the size of the apparatus, and the like, but is normally 0.1 to 3 m/min, and preferably 0.2 to 2.5 m/min.

The pressure inside the chamber 11a is reduced by discharging air from the chamber 11a using the oil diffusion pump 20a connected to a rotary pump. The degree of decompression is normally 1×10⁻² Pa or less, and preferably 1×10⁻³ Pa or less.

An ion implantation gas (e.g., nitrogen) is then introduced into the chamber 11a a through the gas inlet 10a so that the chamber 11a is set an atmosphere of the ion implantation gas under reduced pressure. Note that the ion implantation gas also serves as a plasma-generating gas.

Plasma is then generated using the plasma discharge electrode 4 (external electric field). The plasma may be generated by a known method using a high-frequency electric power supply (e.g., RF power supply or microwave power supply).

A negative high-voltage pulse 9a is applied from the high-voltage pulse power supply 7a connected to the high-voltage-applying rotary can 2a through the high-voltage application terminal 15. When a negative high-voltage pulse is applied to the high-voltage-applying rotary can 2a, ions present in plasma are attracted, and implanted into the surface of the film around the high-voltage-applying rotary can 2a (arrow Y in FIG. 1(a)) so that the film-shaped formed article 1b is obtained.

The pressure during ion implantation (i.e., the pressure of plasma gas inside the chamber 11a) is preferably 0.01 1 to 1 Pa. The pulse width during ion implantation is preferably 1 to 15 µsec. The applied voltage when applying a negative high voltage to the high-voltage-applying rotary can 2a is preferably -1 to -50 kV.

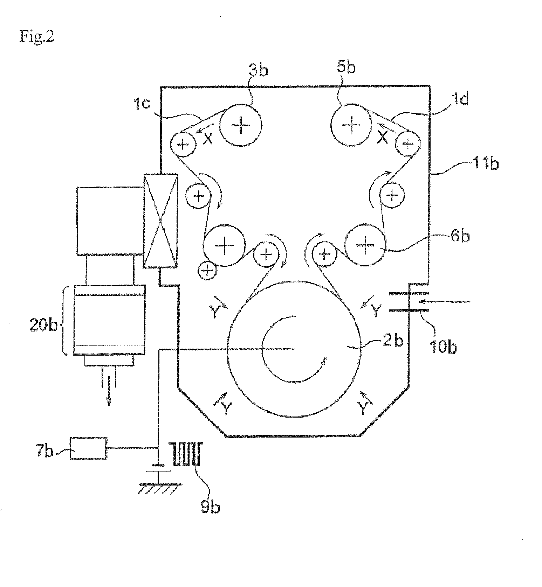

A method of implanting ions into a polycarbosilane compound-containing layer of a film that includes the polycarbosilane compound-containing layer in its surface using a continuous plasma ion implantation apparatus shown in FIG. 2 is described below.

The apparatus shown in FIG. 2 includes the plasma ion implantation apparatus described in (δ). The plasma ion implantation apparatus generates plasma by applying only an electric field due to a high-voltage pulse without using an external electric field (i.e., the plasma discharge electrode 4 shown in FIG. 1).

In the continuous plasma ion implantation apparatus shown in FIG. 2, a film 1c (film-shaped formed article) is fed in an arrow direction X shown in FIG. 2 by rotating a high-voltage-applying rotary can 2b, and wound around a wind-up roll 5b.

The continuous plasma ion implantation apparatus shown in FIG. 2 implants ions into the surface of the polycarbosilane compound-containing layer of the film as follows.

The film 1c is placed in a chamber 11b in the same manner as the plasma ion implantation apparatus shown in FIG. 1. The pressure inside the chamber 11b is reduced by discharging air from the chamber 11b using an oil diffusion pump 20b connected to a rotary pump. An ion implantation gas (e.g., nitrogen) is introduced into the chamber 11b through a gas inlet 10b so that the chamber 11b is filled with the ion implantation gas under reduced pressure.

The pressure during ion implantation (i.e., the pressure of plasma gas inside the chamber 11b) is 10 Pa or less, preferably 0.01 to 5 Pa, and more preferably 0.01 to 1 Pa.

A high-voltage pulse 9b is applied from a high-voltage pulse power supply 7b connected to the high-voltage-applying rotary can 2b through a high-voltage application terminal (not shown) while feeding the film 1c in the direction X shown in FIG. 2.

When a negative high-voltage pulse is applied to the high-voltage-applying rotary can 2b, plasma is generated along the film 1c positioned around the high-voltage-applying rotary can 2b, and ions present in plasma are attracted, and implanted into the surface of the film 1c around the high-voltage-applying rotary can 2b (arrow Y in FIG. 2). When ions have been implanted into the surface of the polycarbosilane compound-containing layer of the film 1c, an ion-implanted layer is formed in the surface of the film. A film-shaped formed article 1d is thus obtained.

The applied voltage and the pulse width employed when applying a negative high-voltage pulse to the high-voltage-applying rotary can 2b, and the pressure employed during ion implantation are the same as those employed when using the continuous plasma ion implantation apparatus shown in FIG. 1.

In the plasma ion implantation apparatus shown in FIG. 2, since the high-voltage pulse power supply also serves as a plasma generation means, a special means such as a high-frequency electric power supply (e.g., RF power supply or microwave power supply) is unnecessary. An ion-implanted layer can be continuously formed by implanting ions present in plasma into the surface of the polycarbosilane compound-containing layer by merely applying a negative high-voltage pulse. Therefore, a formed article in which an ion-implanted layer is formed in the surface of a film can be mass-produced.

### 3) Electronic device member and electronic device

An electronic device member according to one embodiment of the invention includes the formed article according to one embodiment of the invention. Therefore, the electronic device member according to one embodiment of the invention exhibits an excellent gas barrier capability, so that a deterioration in the element (member) due to gas (e.g., water vapor) can be prevented. Since the electronic device member exhibits excellent light transmittance, the electronic device member may suitably be used as a display member for liquid crystal displays, electroluminescence (EL) displays, and the like; a solar battery backsheet; and the like.

An electronic device according to one embodiment of the invention includes the electronic device member according to one embodiment of the invention. Specific examples of the electronic device include a liquid crystal display, an organic EL display, an inorganic EL display, electronic paper, a solar battery, and the like.
Since the electronic device according to one embodiment of the invention includes the electronic device member that includes the formed article according to one embodiment of the invention, the electronic device exhibits an excellent gas barrier capability and excellent bendability.

### EXAMPLES

The invention is further described below by way of examples. Note that the invention is not limited to the following examples.

A plasma ion implantation apparatus, a water vapor transmission rate measuring apparatus, water vapor transmission rate measurement conditions, a visible light transmittance measuring apparatus, visible light transmittance measurement conditions, a folding test method, a surface flatness evaluation method, and an adhesion evaluation method used in the examples are as follows.

### Plasma ion implantation apparatus

RF power supply: "RF56000" manufactured by JEOL Ltd.
High-voltage pulse power supply: "PV-3-HSHV-0835" manufactured by Kurita Seisakusho Co., Ltd.

### Measurement of water vapor transmission rate

The water vapor transmission rate of the formed article was measured before and after the folding test.
Transmission rate analyzer: "L80-5000" manufactured by LYSSY
Measurement conditions: relative humidity: 90%, temperature: 40°C

### Measurement of visible light transmittance

Ultra violet visible near infra red spectrophotometer: "UV3600" manufactured by Shimadzu Corporation
Measurement conditions: wavelength: 550 nm

### Folding test

The formed article was folded at the center so that the ion-implanted surface (i.e., the surface of the polycarbosilane compound-containing layer in Comparative Example 2, and the surface of the silicon nitride film in Comparative Example 4) was positioned outside. The folding is achieved that the formed article was passed through the space between two rolls of a laminator ("LAMIPACKER LPC1502" manufactured by Fujipla, Inc.) at a laminating speed of 5 m/min and a temperature of 23°C.
The folding test was performed in a state in which a pasteboard (thickness: 1 mm) was provided on the inner side of the formed article.

### Surface flatness evaluation method

The surface roughness Ra (nm) (measurement area: 1×1 µm (1 µm square)) was measured using an atomic force microscope (AFM) ("SPA300HV" manufactured by SII NanoTechnology Inc.).

### Adhesion evaluation method

Adhesion between the base and the polycarbosilane compound-containing layer was evaluated by a cross-cut test using an adhesive cellophane tape (JIS K 5600-5-6). The adhesion was evaluated on a scale of 0 (exellent) to 5 (worst).

### Example 1

A solution prepared by dissolving a polycarbosilane compound containing a repeating unit shown by the formula (1) wherein R¹=CH₃, R²=H, and R³=CH₂ ("NIPUSI Type S" manufactured by Nippon Carbon Co., Ltd., Mw=4000) in a toluene/ethyl methyl ketone mixed solvent (toluene:ethyl methyl ketone=7:3, concentration: 5 wt%) was applied to a polyethylene terephthalate film ("PET38 T-100" manufactured by Mitsubishi Plastics Inc., thickness: 38 µm, hereinafter referred to as "PET film") (as a base), and heated at 120°C for 1 minute to form a polycarbosilane compound-containing layer (thickness: 100 nm) (hereinafter referred to as "polycarbosilane layer") on the PET film. A formed body was thus obtained. Argon (Ar) ions were then plasma-implanted into the surface of the polycarbosilane layer using the plasma ion implantation apparatus shown in FIG. 2 to obtain a formed article 1.

The following plasma ion implantation conditions were employed.
Gas (argon) flow rate: 100 sccm
Duty ratio: 0.5%
Repetition frequency: 1000 Hz
Applied voltage: -10 kV
RF power supply: frequency: 13.56 MHz, applied electric power: 1000 W
Chamber internal pressure: 0.2 Pa
Pulse width: 5 µsec
Processing time (ion implantation time): 5 minutes
Line (feed) speed: 0.2 m/min

### Example 2

A formed article 2 was obtained in the same manner as in Example 1, except for using helium (He) as the plasma-generating gas instead of argon.

### Example 3

A formed article 3 was obtained in the same manner as in Example 1, except for using nitrogen (N₂) as the plasma-generating gas instead of argon.

### Example 4

A formed article 4 was obtained in the same manner as in Example 1, except for using krypton (Kr) as the plasma-generating gas instead of argon.

### Example 5

A formed article 5 was obtained in the same manner as in Example 1, except for using oxygen (O₂) as the plasma-generating gas instead of argon.

### Example 6

A formed article 6 was obtained in the same manner as in Example 1, except for changing the applied voltage during ion implantation to -15 kV.

### Example 7

A formed article 7 was obtained in the same manner as in Example 1, except for changing the applied voltage during ion implantation to -20 kV.

### Example 8

A formed article 8 was obtained in the same manner as in Example 1, except for using a low-molecular-weight product ("NIPUSI Type L" manufactured by Nippon Carbon Co., Ltd., Mw=800) of the polycarbosilane compound used in Example 1 as the polycarbosilane compound.

### Example 9

A formed article 9 was obtained in the same manner as in Example 1, except for using a polycarbosilane compound containing a repeating unit shown by the formula (1) wherein R¹=CH3, R²=CH₂CH₂CH₃, and R³=C₆H₄ (Mw=3000) as the polycarbosilane compound.

### Comparative Example 1

The PET film was directly used as a formed article 10.

### Comparative Example 2

A polycarbosilane layer was formed on the PET film in the same manner as in Example 1 to obtain a formed article 11.

### Comparative Example 3

A formed article was obtained in the same manner as in Example 1, except that the polycarbosilane layer was not formed. Specifically, the PET film was ion-implanted in the same manner as in Example 1 to obtain a formed article 12.

### Comparative Example 4

A silicon nitride (SiN) film (thickness: 50 nm) was formed on the PET film by sputtering to obtain a formed article 13.

### Comparative Example 5

A urethane acrylate layer (thickness: 1 µm) ("URETHANE ACRYLATE 575BC" manufactured by Arakawa Chemical Industries, Ltd.) was ion-implanted in the same manner as in Example 1 to obtain a formed article 14.

In Examples 1 to 9 and Comparative Examples 3 and 5, implantation of ions was confirmed by subjecting the surface (depth: about 10 nm) of the formed article to elemental analysis using an XPS system ("Quantum 2000" manufactured by ULVAC-PHI, Incorporated).

The formed articles 1 to 14 obtained in Examples 1 to 9 and Comparative Examples 1 to 5 were subjected to measurement of the water vapor transmission rate, measurement of the visible light transmittance, measurement of the surface roughness (Ra), and the adhesion test. The measurement results and the evaluation results are shown in Table 1.

The formed articles 1 to 14 were subjected to the folding test, and the water vapor transmission rate was measured after the folding test. The results are shown in Table 1.

**TABLE 1**

| | Formed article | Water vapor transmission rate (g/m²/day) | | Visible light transmittance (%) | Ra (nm) | Adhesion test (0 (excellent) to 5 (worst)) |
|---|---|---|---|---|---|---|
| | | Before folding test | After folding test | | | |
| Example 1 | 1 | 0.12 | 0.48 | 83.0 | 0.20 | 0 |
| Example 2 | 2 | 0.09 | 0.41 | 82.4 | 0.15 | 0 |
| Example 3 | 3 | 0.15 | 0.53 | 83.3 | 0.24 | 0 |
| Example 4 | 4 | 0.16 | 0.49 | 82.6 | 0.21 | 0 |
| Example 5 | 5 | 0.31 | 0.55 | 84.2 | 0.19 | 0 |
| Example 6 | 6 | 0.07 | 0.44 | 82.0 | 0.12 | 0 |
| Example 7 | 7 | 0.05 | 0.50 | 81.7 | 0.13 | 0 |
| Example 8 | 8 | 0.22 | 0.87 | 82.2 | 0.18 | 0 |
| Example 9 | 9 | 0.10 | 0.32 | 78.8 | 0.20 | 0 |
| Comparative Example 1 | 10 | 13.7 | 14.0 | 86.9 | 0.98 | - |
| Comparative Example 2 | 11 | 13.2 | 13.3 | 87.8 | 1.10 | 0 |
| Comparative Example 3 | 12 | 7.98 | 9.37 | 7.14 | 0.33 | - |
| Comparative Example 4 | 13 | 0.55 | 1.21 | 81.1 | 1.50 | 1 |
| Comparative Example 5 | 14 | 10.0 | 13.3 | 74.6 | 0.55 | 1 |

As shown in Table 1, the formed articles 1 to 9 obtained in Examples 1 to 9 had a low water vapor transmission rate (i.e., excellent gas barrier capability) as compared with the formed articles 10 and 14 obtained in Comparative Examples 1 to 5. The formed articles 1 to 9 also exhibited excellent transparency, surface flatness, and adhesion. The formed articles 1 to 9 showed a small increase in water vapor transmission rate after the folding test (i.e., exhibited excellent bendability).

### LIST OF REFERENCE SYMBOLS

1a, 1c: Film-shaped formed body
1b, 1d: Film-shaped formed article
2a, 2b: Rotary can
3a, 3b: Feed-out roll
4: Plasma discharge electrode
5a, 5b: Wind-up roll
6a, 6b: Driving roll
7a, 7b: Pulse power supply
9a, 9b: High-voltage pulse
10a, 10b: Gas inlet
11a, 11b: Chamber
13: Center shaft
15: High-voltage application terminal
20a, 20b: Oil diffusion pump

## Claims

1. A formed article comprising a layer obtained by implanting ions into a polycarbosilane compound-containing layer.

2. The formed article according to claim 1, wherein the polycarbosilane compound includes a repeating unit shown by a formula (1), 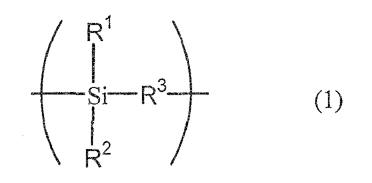 wherein R¹ and R² individually represent a hydrogen atom, a hydroxyl group, an alkyl group, an aryl group, an aralkyl group, an alkenyl group, or a monovalent heterocyclic group, provided that R¹ and R² may respectively be either the same or different, and R³ represents an alkylene group, an arylene group, or a divalent heterocyclic group.

3. The formed article according to claim 1 or 2, wherein the layer is obtained by implanting ions into the polycarbosilane compound-containing layer by a plasma ion implantation method.

4. The formed article according to any one of claims 1 to 3, the formed article having a water vapor transmission rate at a temperature of 40°C and a relative humidity of 90% of less than 0.3 g/m²/day.

5. A method of producing the formed article according to claim 1, the method comprising implanting ions into a surface of a polycarbosilane compound-containing layer of a formed body that includes the polycarbosilane compound-containing layer in its surface.

6. The method according to claim 5, comprising implanting ions into the polycarbosilane compound-containing layer while feeding a long formed body that includes the polycarbosilane compound-containing layer in its surface in a given direction.

7. An electronic device member comprising the formed article according to any one of claims 1 to 4.

8. An electronic device comprising the electronic device member according to claim 7.
